(19) Europäisches Patentamt / European Patent Office / Office européen des brevets

(11) **EP 4 528 337 A2**

(12) **DEMANDE DE BREVET EUROPEEN**

(43) Date de publication:
**26.03.2025  Bulletin 2025/13**

(51) Classification Internationale des Brevets (IPC):
**G02B 1/00** (2006.01)     **G02B 5/20** (2006.01)
**G02B 5/28** (2006.01)

(21) Numéro de dépôt: **24195793.5**

(22) Date de dépôt: **22.08.2024**

(52) Classification Coopérative des Brevets (CPC):
**G02B 1/002; G02B 5/201; G02B 5/284; H10F 77/40**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(30) Priorité:   **29.08.2023  FR 2309032**

(71) Demandeur: **Commissariat à l'Energie Atomique et aux Energies Alternatives**
**75015 Paris (FR)**

(72) Inventeurs:
• **PALANCHOKE, Ujwol**
  **38054 GRENOBLE CEDEX 09 (FR)**
• **BERARD-BERGERY, Sébastien**
  **38054 GRENOBLE CEDEX 09 (FR)**
• **LANDIS, Stefan**
  **38054 GRENOBLE CEDEX 09 (FR)**

(74) Mandataire: **Cabinet Camus Lebkiri**
  **25 rue de Maubeuge**
  **75009 Paris (FR)**

(54) **FILTRE MULTISPECTRAL POUR UNE RADIATION ÉLECTROMAGNÉTIQUE ET PROCÉDÉ DE FABRICATION DUDIT FILTRE**

(57)     L'invention concerne un filtre multispectral (100) pour une radiation électromagnétique, ledit filtre comportant au moins deux filtres de couleur ($F_i$), chaque filtre de couleur comportant :
- un réseau métallique comportant des motifs métalliques ($102i$) répétés selon une période donnée (P), chaque motif métallique étant espacé d'un motif métallique adjacent d'un écart ($W_i$) donné non nul ;
- une couche réfléchissante continue ($104i$) ;
- un motif ($103i$) de matériau diélectrique de cavité de Fabry-Pérot entre le réseau métallique et la couche réfléchissante continue ;

l'épaisseur ($T_i$) des motifs de matériau diélectrique des deux filtres de couleur étant différente.

Fig. 6

EP 4 528 337 A2

**Description**

**DOMAINE TECHNIQUE DE L'INVENTION**

Le domaine technique de l'invention est celui du filtrage spectral, notamment pour des applications d'imagerie et la réalisation de filtres colorés pour les capteurs d'images de type CMOS, les dispositifs d'affichage à cristaux liquides ou des diodes électroluminescentes. L'invention peut également être mise en en oeuvre dans des dispositifs d'émission de la lumière.

La présente invention concerne un filtre multispectral pour une radiation électromagnétique.

**ARRIERE-PLAN TECHNOLOGIQUE DE L'INVENTION**

Un filtre spectral ou encore un filtre de couleur permet de filtrer la lumière par longueur d'onde, de façon à fournir une information sur l'intensité de la lumière dans certaines longueurs d'onde. Plusieurs filtres de couleur peuvent être associés de façon à former, par exemple, des filtres rouge-vert-bleu (RGB dans la terminologie anglaise) qui renseignent sur l'intensité de ces trois couleurs.

On connait notamment des filtres de couleur de type métal/diélectrique réalisés à partir d'une cavité de Fabry-Pérot. Ces filtres comprennent une ou plusieurs cavités diélectriques (ou éventuellement semiconductrices) formées entre deux films minces de métal ayant une fonction de miroir métallique de façon à former une cavité de Fabry-Pérot. Généralement, les empilements métal/diélectrique sont différents suivant la position sur le composant optoélectronique (un capteur d'image par exemple). La longueur d'onde de transmission du filtre est réglée en ajustant l'épaisseur de la cavité. Ainsi, en fonctionnement, une partie de la lumière incidente correspondant à la longueur d'onde du filtre est transmise à travers celui-ci sous la forme d'un faisceau coloré, tandis que le reste de la lumière incidente est réfléchie. De façon générale, l'épaisseur de la couche diélectrique fixe la longueur d'onde centrale transmise, tandis que l'épaisseur des couches métalliques permet de régler la largeur spectrale de transmission. Par ailleurs, l'utilisation de plusieurs cavités de Fabry-Pérot permet de modifier le profil spectral de la transmission du filtre. Un filtre de ce type est réalisé en utilisant des techniques classiques de fabrication de semi-conducteurs. Ainsi, pour obtenir un filtre rouge-vert-bleu, il convient de former au moins une cavité diélectrique dont l'épaisseur doit présenter trois valeurs différentes. Pour certaines applications, il peut être intéressant de régler non seulement la longueur d'onde centrale de transmission (via l'épaisseur de la couche diélectrique) mais aussi la bande passante de transmission.

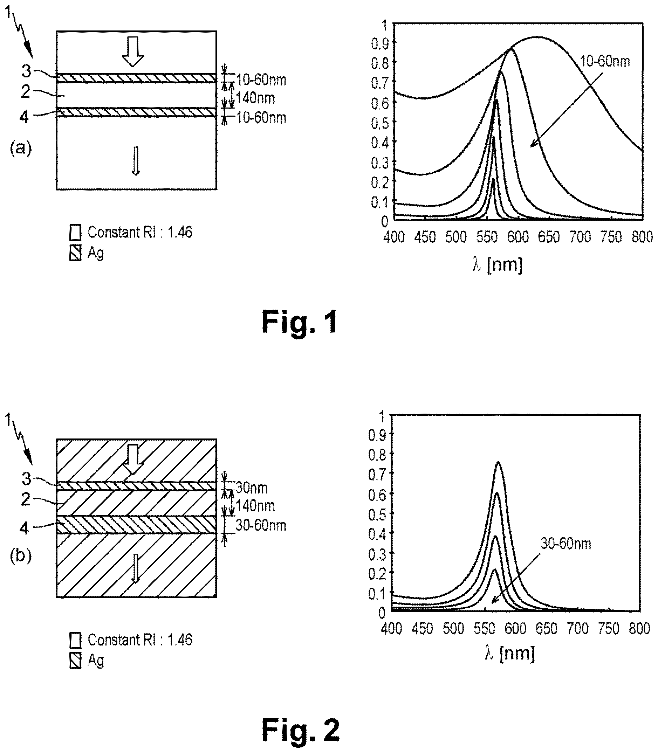

La bande passante des spectres transmis peut notamment être ajustée en faisant varier l'épaisseur du métal [ cf. I. L. Gomes de Souza, V. F. Rodriguez-Esquerre et D. F. Rêgo, "Filtres grand angle à base de nanorésonateurs pour le spectre visible", Appl. Opter. 57, 6755-6759 (2018)]. La figure 1 montre la réponse spectrale d'un filtre 1 à cavité Fabry-Pérot comportant une couche diélectrique 2 d'une épaisseur de 140 nm entre deux couches réfléchissantes métalliques 3 et 4 de même épaisseur lorsque les deux épaisseurs des couches métalliques réfléchissantes 3 et 4 varient entre 10 et 60 nm. Il ressort de la figure qu'en augmentant l'épaisseur du métal des deux couches 3 et 4, la bande passante de transmission diminue (d'environ 100 nm à environ 10 nm). On observe toutefois simultanément une diminution de la transmission maximale de 0.9 à environ 0.2. Il y a donc une contrepartie négative sur la valeur de la transmission maximale lorsqu'on cherche à réduire la bande passante du filtre.

Le réglage de la bande passante peut également être réalisé en faisant varier une seule épaisseur de métal, par exemple l'épaisseur de la couche réfléchissante 4, comme illustré à la figure 2 (l'épaisseur de la couche réfléchissante 3 restant constante et égale à 30 nm). Cependant, à partir des résultats de simulation, on observe à nouveau qu'en augmentant l'épaisseur d'une seule couche de métal, la transmission maximale diminue. Il parait donc être difficile d'obtenir une bande passante de transmission étroite tout en maintenant un coefficient de transmission plus élevé avec des filtres à cavité Fabry-Pérot.

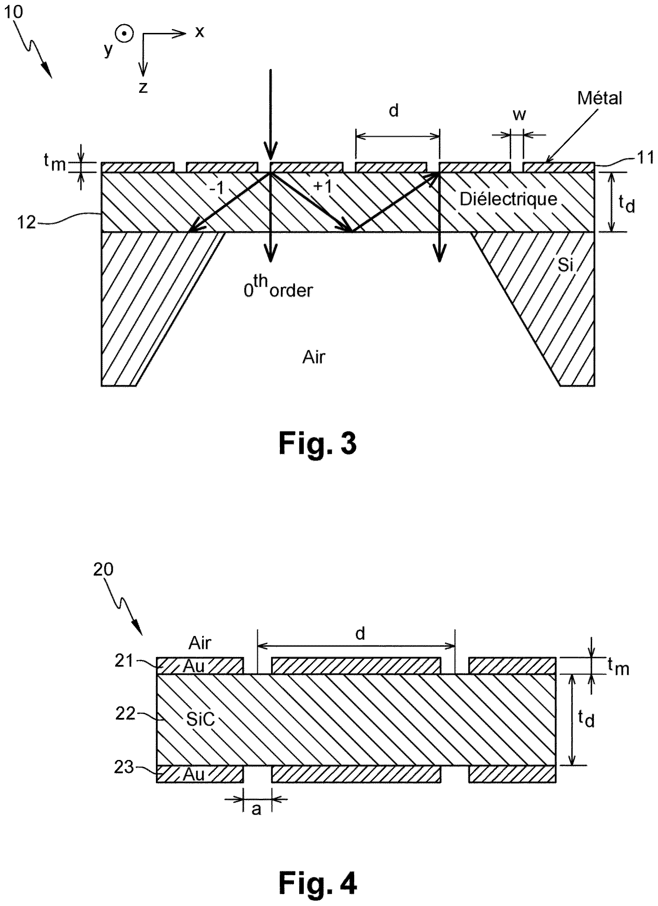

Une solution connue permettant de trouver un bon compromis entre l'obtention d'une bande passante étroite et une transmission maximale qui ne soit pas trop réduite consiste à utiliser des filtres à résonance de mode guidé GMR (Guided Mode Résonance selon la terminologie anglaise). Ces filtres peuvent être mis en oeuvre dans le visible ou dans l'infrarouge. On trouvera un exemple d'un tel filtre dans la publication « Structures métal-diélectriques à résonance de mode guidé et applications au filtrage et à l'imagerie infrarouge » (Optics / Photonic. Ecole Polytechnique X, 2013 - Sakat et al.). La figure 3 illustre la structure d'un filtre GMR 10 dans l'infrarouge. Le filtre 10 comporte un réseau métallique 11 (« grating layer » selon la terminologie anglaise) comportant des motifs métalliques espacés d'un écart w (formant ainsi des fentes entre chaque motif) placés sur une couche diélectrique 12 qui joue le rôle d'un guide d'onde. Les motifs métalliques sont répétés selon une période d. Le couplage entre le mode de guide d'onde et les résonances des motifs métalliques donne une longueur d'onde de résonance. La longueur d'onde dépend essentiellement de l'épaisseur de la couche diélectrique 12. En ajustant les différents paramètres, notamment la période p, l'écart w et l'épaisseur des motifs métalliques tm, il est possible de réduire la bande passante de transmission tout en conservant une transmission maximale acceptable.

Plus récemment, des structures de filtre comportant une couche diélectrique prise entre deux réseaux métalliques ont été décrites, fonctionnant tant dans le visible que dans l'infrarouge. Un exemple d'un tel filtre 20 est représenté en figure 4. Le filtre 20 comporte un premier réseau métallique 21 comportant des motifs métalliques disposés périodiquement selon une période d et espacés d'un écart a, placés sur une couche diélectrique 22 qui joue le rôle d'un guide d'onde, elle-même au-dessus d'un second réseau métallique 23 semblable au premier réseau 21. A nouveau, les différents paramètres que sont l'épaisseur td de la couche diélectrique, la période d, l'écart a et l'épaisseur des motifs métalliques tm, vont permettre de régler la longueur d'onde de transmission, la bande passante et la transmission maximale.

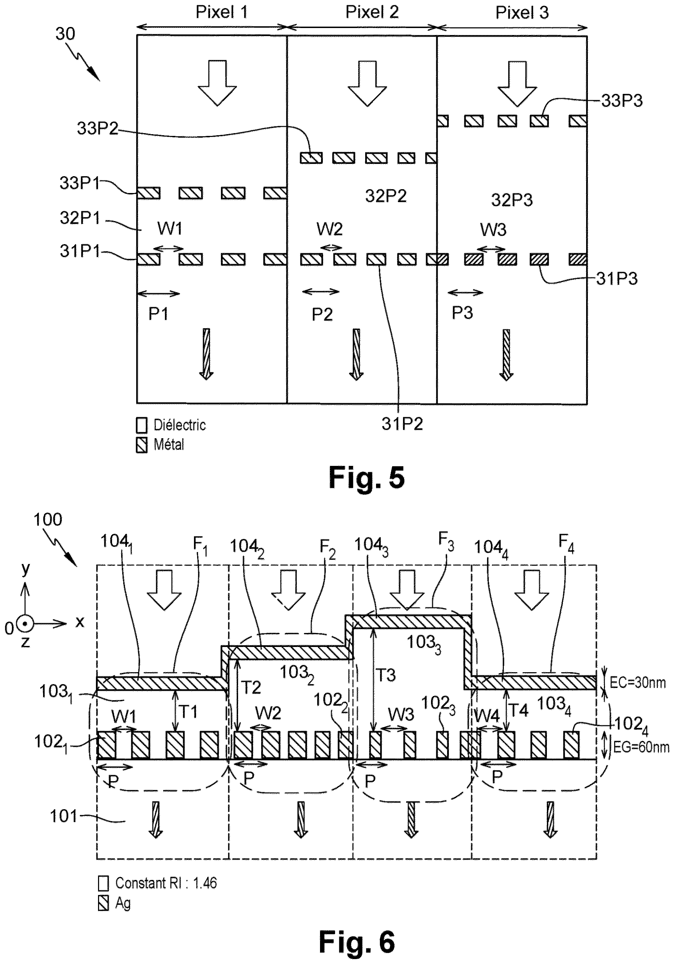

Même si la structure de la figure 3 offre des performances satisfaisantes en termes de compromis entre la transmission maximale et la largeur de la bande passante, elle reste peu adaptée à une mise en oeuvre pour des filtres multispectraux utilisant capteurs pixélisés. En effet, une telle application nécessiterait de réaliser dans la même structure, plusieurs filtres de couleurs différents (typiquement rouge, bleu et vert) avec, pour chacun, deux réseaux métalliques différents. Une telle structure 30 est illustrée en figure 5. Elle comprend 3 filtres (Pixel i, i variant de 1 à 3) comportant chacun respectivement :

- un premier réseau métallique 31 Pi comportant des motifs métalliques disposés périodiquement selon une période Pi et espacés d'un écart Wi,

- une couche diélectrique 32Pi qui joue le rôle d'un guide d'onde,

- un second réseau métallique 33Pi.

On notera que chaque couche diélectrique 32Pi a ici une épaisseur différente pour laisser passer la longueur d'onde correspondante.

Ainsi, deux réseaux métalliques (inférieur et supérieur) doivent être fabriqués en utilisant des techniques de lithographies standards. Autant le réseau inférieur 31Pi peut être obtenu de façon standard, autant le réseau supérieur 33Pi est beaucoup plus complexe à réaliser sur des couches diélectriques d'épaisseur différente du fait notamment de l'alignement nécessaire des deux réseaux métalliques supérieures et inférieures, de la nécessité de bien contrôler les périodes et les écarts différents pour les réseaux de chaque pixel. Une telle fabrication nécessite de nombreuses étapes technologiquement complexes.

En outre, pour que le filtre de résonance en mode guidé fonctionne efficacement, une répétition plus élevée de la période de réseau est nécessaire. De plus, pour obtenir une transmission de différentes longueurs d'onde, une période de réseau différente doit être utilisée pour chaque pixel. La difficulté à maitriser la réalisation technologique des réseaux peut donc entraîner des problèmes de performances des capteurs d'image pixélisés. Enfin, avec une taille de pixel prédéfinie pour chaque pixel, le nombre de motifs métalliques est différent pour les différents pixels, entraînant là encore des difficultés de réalisation.

**RESUME DE L'INVENTION**

L'invention offre une solution aux problèmes évoqués précédemment, en proposant un filtre multispectral pour une radiation électromagnétique avec un bon compromis entre la transmission maximale pour chaque longueur d'onde et la largeur de la bande passante, tout en s'affranchissant des problèmes de fabrication mentionnés ci-dessus.

Pour ce faire, l'invention a pour objet un filtre multispectral pour une radiation électromagnétique, ledit filtre comportant au moins deux filtres de couleur, chaque filtre de couleur comportant :

- un réseau métallique comportant des motifs métalliques répétés selon une période donnée, chaque motif métallique étant espacé d'un motif métallique adjacent d'un écart donné non nul ;

- une couche réfléchissante continue ;

- un motif de matériau diélectrique de cavité de Fabry-Pérot entre le réseau métallique et la couche réfléchissante continue ;

l'épaisseur des motifs de matériau diélectrique des deux filtres de couleur étant différente.

Grâce à l'invention, le filtre à cavités de Fabry Pérot est réalisé avec un réflecteur classique métallique continu tandis que le second réflecteur est un réseau métallique discontinu de type « métal grating layer ». Une telle architecture offre à la fois la souplesse de réglage des filtres à double grating et une simplicité de fabrication dans la mesure où seule une couche discontinue doit être réalisée. En outre, il est parfaitement possible de réaliser un filtre conforme à l'invention permettant de filtrer différentes couleurs (rouge, bleu, vert par exemple) avec une période de répétition des motifs du réseau métallique qui reste constante, quelle que soit la couleur, et en ajustant par exemple l'écart entre les motifs d'une couleur à l'autre. Comme nous le verrons plus tard, le filtre selon l'invention permet d'obtenir des performances plus satisfaisantes en termes de compromis entre la transmission maximale et l'étroitesse de la bande passante (notamment vis-à-vis des filtres classiques dans lesquels l'épaisseur de métal est augmentée). On notera que le filtre selon l'invention agit comme un résonateur à cavité de Fabry-Pérot formée par le tri-couche « couche métallique continue - couche diélectrique - réseau métallique » et que la longueur d'onde filtrée est essentiellement déterminée par l'épaisseur de la couche diélectrique. La présence d'au moins deux épaisseurs différentes assure donc un fonctionnement sur au moins deux longueurs d'onde et donc la réalisation d'un filtre pixélisé, chaque pixel correspondant à une longueur d'onde.

Outre les caractéristiques qui viennent d'être évoquées dans le paragraphe précédent, le filtre selon l'invention peut présenter une ou plusieurs caractéristiques complémentaires parmi les suivantes, considérées individuellement ou selon toutes les combinaisons techniquement possibles :

- la période de répétition des motifs métalliques est identique pour les deux filtres de couleur ; le filtre selon l'invention peut conserver cette période identique pour un nombre quelconque de filtres de couleur supérieur ou égal à 2 ;

- l'épaisseur du réseau métallique des deux filtres de couleur est identique ; le filtre selon l'invention peut conserver cette épaisseur identique pour un nombre quelconque de filtres de couleur supérieur ou égal à 2 ;

- l'épaisseur de la couche réfléchissante des deux filtres de couleur est identique ; le filtre selon l'invention peut conserver cette épaisseur identique pour un nombre quelconque de filtres de couleur supérieur ou égal à 2 ;

- chacun des deux filtres est en regard d'un transducteur photoélectrique. On entend par « transducteurs photoélectriques » des dispositifs qui peuvent fonctionner soit en tant que collecteur de lumière issue des filtres soit en tant qu'émetteur de lumière vers les filtres. S'il s'agit de collecteurs, les transducteurs peuvent être par exemple des photodiodes de type CMOS. S'il s'agit d'émetteurs, les transducteurs peuvent être par exemple des diodes LED, des diodes de type QLED ou des diodes LASER, les émetteurs présentant dans ce cas un spectre d'émission plus large que celui des cavités de Fabry-Pérot correspondantes ;

- l'espace entre chaque motif métallique est rempli du matériau diélectrique formant les motifs de matériau diélectrique de cavité de Fabry-Pérot des filtres de couleur ;

- la période de répétition des motifs métalliques de chaque réseau métallique est choisie pour être strictement inférieure à la longueur d'onde du filtre de couleur correspondant ;

- on notera que les réseaux métalliques sont préférentiellement localisés sur la partie inférieure du filtre tandis que les couches réfléchissantes continues sont localisées sur la partie supérieure du filtre pour des raisons de facilité de fabrication ; nous verrons toutefois qu'il est également possible de fabriquer un filtre multispectral selon l'invention avec des réseaux métalliques localisés sur la partie supérieure du filtre et des couches réfléchissantes continues localisées sur la partie inférieure du filtre.

L'invention a également pour objet un procédé de fabrication d'un filtre multispectral pour une radiation électromagnétique selon un premier mode de réalisation de l'invention comportant les étapes suivantes :

- Dépôt d'une première couche de résine sur un substrat ;

- Structuration de la première couche de résine de façon à obtenir au moins deux séries de tranchées dans la première couche de résine, chaque tranchée d'une série étant espacée d'une tranchée adjacente de la série d'un écart donné non nul, les tranchées étant répétées selon une période donnée ;

- Dépôt d'une couche de métal dans les tranchées et sur la résine restante ;

- Retrait de la résine restante et du métal se trouvant sur la résine restante de façon à conserver deux réseaux métalliques comportant chacun des motifs métalliques répétés selon la période donnée d'une des séries de tranchées, chaque motif métallique étant espacé d'un motif métallique adjacent de l'écart donné non nul d'une des séries de tranchées ;

- Dépôt d'une couche de matériau diélectrique plane destinée à former au moins deux motifs de matériau diélectrique de cavité de Fabry-Pérot, ladite couche présentant l'épaisseur du motif diélectrique de cavité de Fabry-Pérot maximale ;

- Dépôt d'une couche de résine sur la couche de matériau diélectrique et retrait de ladite couche de résine avec arrêt sur la couche diélectrique au niveau la zone au-dessus d'un des deux réseaux métalliques ;

- Gravure de la couche diélectrique au niveau de la zone de retrait de résine de façon à obtenir un premier motif diélectrique de cavité Fabry-Pérot ;

- Retrait de la résine restante de façon à laisser apparent un second motif diélectrique de cavité de Fabry-Pérot présentant l'épaisseur de motif diélectrique maximale, l'épaisseur du premier motif diélectrique étant inférieure à l'épaisseur du premier motif diélectrique ;

- Dépôt d'une couche métallique continue sur les premier et deuxième motifs diélectrique.

Selon ce premier mode de fabrication, les réseaux métalliques sont préférentiellement localisés sur la partie inférieure du filtre tandis que les couches réfléchissantes continues sont localisées sur la partie supérieure du filtre.

L'invention a également pour objet un procédé de fabrication d'un filtre multispectral pour une radiation électromagnétique selon un second mode de réalisation de l'invention comportant les étapes suivantes :

- Dépôt sur un substrat d'une couche de matériau de structuration;

- Structuration de la couche de matériau de structuration de sorte à obtenir au moins deux motifs de matériau de structuration de hauteurs différentes, au moins un des motifs présentant une hauteur maximale de référence relativement au substrat, la hauteur étant mesurée perpendiculairement au plan du substrat ;

- Dépôt d'une couche métallique continue sur les au moins deux motifs de matériau de structuration ;

- Dépôt d'une couche réalisée dans le matériau diélectrique destiné à former au moins deux motifs diélectriques de cavités de Fabry-Pérot, ladite couche de matériau diélectrique recouvrant la totalité des motifs de matériau de structuration en présentant une surface supérieure dont chaque point est situé à une hauteur supérieure à la hauteur maximale de référence ;

- Planarisation par retrait du matériau diélectrique avec arrêt sélectif au sommet du motif de matériau de structuration le plus haut recouvert de la couche métallique continue ;

- Dépôt d'une couche réalisée dans le même matériau diélectrique de façon à finaliser la formation des au moins deux motifs diélectriques de cavité Fabry-Pérot ;

- Dépôt d'une seconde couche métallique sur les au moins deux motifs de cavités diélectriques de cavité Fabry-Pérot ;

- Structuration de la seconde couche métallique de façon à former au moins deux réseaux métalliques comportant chacune des motifs métalliques répétés selon une période donnée, chaque motif métallique étant espacé d'un motif métallique adjacent d'un écart donné non nul.

Selon ce second mode de fabrication, le filtre multispectral selon l'invention comporte des réseaux métalliques localisés sur la partie supérieure du filtre et des couches réfléchissantes continues localisées sur la partie inférieure du filtre.

Avantageusement, le matériau de structuration est une résine, ladite étape de structuration étant réalisée par une étape de lithographie en niveau de gris dite Grayscale sur la couche de matériau de structuration.

L'invention et ses différentes applications seront mieux comprises à la lecture de la description qui suit et à l'examen des figures qui l'accompagnent.

## BREVE DESCRIPTION DES FIGURES

Les figures sont présentées à titre indicatif et nullement limitatif de l'invention.

- La [Fig. 1] illustre l'effet de l'épaisseur des deux couches réfléchissantes d'un filtre à cavité Fabry-Pérot de l'état de l'art sur la transmission et la bande passante du filtre ;

- La [Fig. 2] illustre l'effet de l'épaisseur d'une des deux couches réfléchissantes d'un filtre à cavité Fabry-Pérot de l'état de l'art sur la transmission et la bande passante du filtre ;

- La [Fig.3] illustre un filtre à résonance de mode guidé GMR à simple réseau métallique selon l'état de la technique ;

- La [Fig. 4] illustre un filtre à résonance de mode guidé GMR à double réseau métallique selon l'état de la technique ;

- La [Fig. 5] illustre un filtre multispectral comportant une pluralité de filtres selon la [Fig. 4] ;

- La [Fig. 6] illustre un filtre multispectral selon un premier mode de réalisation de l'invention ;

- La [Fig. 7] montre une comparaison des spectres de transmission pour trois structures de filtre de couleur différentes dont un filtre de couleur utilisé dans un filtre selon l'invention ;

- Les [Fig. 8] et [Fig. 9] montrent les réponses spectrales d'un filtre multispectral selon l'état de l'art et d'un filtre multispectral selon l'invention ;

- La [Fig. 10] montre une cartographie de transmission en fonction de l'écart entre les motifs d'un réseau métallique d'un filtre de couleur d'un filtre multispectral selon l'invention ;

- La [Fig. 11] montre un autre exemple de réponse spectrale d'un filtre multispectral selon l'invention avec une période différente de celle des figures 8 et 9 ;

- La [Fig. 12] illustre les différentes étapes d'un procédé de fabrication d'un filtre multispectral selon le premier mode de réalisation de l'invention ;

- La [Fig. 13] illustre un filtre multispectral selon un second mode de réalisation de l'invention

- La [Fig. 14] montre la superposition de la réponse spectrale de deux filtres de couleur utilisé respectivement dans le filtre de la figure 6 et dans le filtre de la figure 13 ;

- La [Fig. 15] illustre les différentes étapes d'un procédé de fabrication d'un filtre multispectral selon le second mode de réalisation de l'invention.

## DESCRIPTION DETAILLEE

Les figures sont présentées à titre indicatif et nullement limitatif de l'invention.

Il convient de rappeler au préalable que, de façon générale et bien connue de l'homme du métier, un filtre de couleur de type métal/diélectrique réalisé à partir d'une cavité de Fabry-Pérot est obtenu en dimensionnant l'épaisseur de la couche diélectrique formée entre les deux couches métalliques. Si le filtrage de plusieurs couleurs est recherché sur un même composant, il est alors nécessaire d'être en mesure d'obtenir une épaisseur de diélectrique d'épaisseur variable sur ce même composant.

Ce dimensionnement est par exemple réalisé à l'aide d'un programme de calcul électromagnétique tel que le formalisme de transfert de matrices d'Abeles ou un calcul de diffraction pour les pixels dont la taille est proche de la longueur d'onde tel que le formalisme de la Méthode Modale par Expansion de Fourier ou l'analyse rigoureuse par ondes couplées (RCWA selon la terminologie anglaise).

Ces programmes de calcul permettent de déterminer les paramètres optimaux des empilements métal diélectrique pour chaque pixel. Le calcul prend notamment en compte les épaisseurs des couches de métal et de diélectrique ainsi que leurs indices, le spectre et la distribution angulaire de la lumière incidente. Par exemple, dans le cas des filtres de Fabry-Pérot, la longueur d'onde centrale du filtre est déterminée approximativement par la formule suivante:

$$\lambda_0 = \frac{2\pi h_{cavity}\sqrt{n^2_{cavity}-sin^2\theta_{in}}}{\pi+\varphi}$$

où

- $h_{cavity}$ est l'épaisseur de la cavité, c'est-à-dire approximativement l'épaisseur de la couche diélectrique

- $n_{cavity}$ est l'indice effectif de la cavité,

- $\varphi$ est le déphasages à la réflexion sur le miroir métallique (déterminés par la nature des matériaux en jeu et la longueur d'onde considérée),

- $\theta_{in}$ est l'angle d'incidence de la lumière incidente sur le filtre (compté à partir de la perpendiculaire à la surface du filtre).

Une fois l'angle d'attaque connu, l'indice et le déphasage connus, il ne reste plus alors qu'à déterminer une épaisseur approximative pour que la cavité soit centrée sur une longueur d'onde particulière. Une fois la fonction de filtrage calculée pour chaque filtre et chaque longueur d'onde, les épaisseurs h des diélectriques sont alors ajustées en fonction des performances recherchées (recherche d'un bon rapport signal sur bruit, d'un maximum de transmission, etc.).

Une autre méthode plus empirique consiste à calculer, pour plusieurs épaisseurs h, la réponse de l'empilement et à choisir h tel que le pic de résonance du filtre ($\lambda res$) soit positionné conformément au cahier des charges.

La figure 6 illustre un filtre multispectral 100 selon l'invention.

Le filtre multispectral 100 comporte une pluralité de filtres de couleurs Fi (i étant un entier supérieur ou égal à 2) réalisés sur un substrat 101 pouvant être par exemple être un substrat en Si, un substrat Silicium sur Isolant SOI (pour « Silicon On Insulator » selon la terminologie anglaise) ou un substrat en verre ou en saphir. Ici, 4 filtres de couleurs F1 à F4 (dont deux filtres identiques F1 et F4) sont représentés à des fins d'illustration uniquement.

Chaque filtre de couleur Fi vise à laisser passer un spectre de transmission avec une longueur centrale donnée, une transmission maximale donnée et une bande passante donnée et comporte :

- Une couche métallique réfléchissante discontinue 102i formée par un réseau métallique sensiblement plan comportant une pluralité de motifs métalliques 103i, chaque motif métallique 103i étant répété avec une période P mesurée suivant l'axe Ox, étant espacé du ou des motifs adjacent(s) d'un écart non nul Wi mesuré suivant l'axe Ox et ayant une épaisseur EG mesurée suivant l'axe Oy (Oxy étant le plan de la figure et l'axe Oy étant selon la direction perpendiculaire au plan du substrat 101) ;

- Une couche diélectrique 103i d'épaisseur Ti formant un motifs diélectrique de cavité de Fabry-Pérot, ladite couche étant en contact sur sa surface inférieure avec la couche métallique discontinue 102i ;

- Une couche métallique réfléchissante continue 104i d'épaisseur EC mesurée suivant l'axe Oy en contact avec la surface supérieure de la couche diélectrique 103i.

Les motifs métalliques des réseaux 102i sont ici représentés sous la forme de lames parallélépipédiques s'étendant selon l'axe Oz perpendiculaire au Oxy, étant entendu que ces motifs peuvent présenter d'autres formes telles que des formes de piliers cylindriques (carrés, circulaires, elliptiques, ...) espacés les uns des autres d'un écart Wi et répétés selon une période P.

De manière préférentielle, la période P est constante pour tous les réseaux métalliques 102i. Il en est de même de l'épaisseur EG qui est également préférentiellement constante pour tous les réseaux métalliques 102i et de l'épaisseur EC qui est également préférentiellement constante pour toutes les couches réfléchissantes continues 104i. La période P de répétition est avantageusement choisie pour être strictement inférieure aux longueurs d'onde des filtres de couleur formant le filtre selon l'invention.

Le matériau utilisé pour les couches métalliques réfléchissantes 102i et 104i est préférentiellement identique et peut être par exemple de l'Ag ou de l'Au pour des applications dans le visible.

Le matériau utilisé pour les motifs diélectriques 103i peut être par exemple du $SiO_2$, du SiN ou même une résine destinée à être utilisée en lithographie.

De manière avantageuse, chaque espace entre les motifs métalliques des réseaux 102i est remplie du matériau diélectrique utilisé pour les motifs diélectriques 103i.

L'ensemble des couches métalliques 104i peut être vu comme une couche métallique continue d'épaisseur constante EC à marches d'escalier recouvrant les surfaces supérieures des motifs diélectriques 103i ainsi que, optionnellement, les flancs de ses derniers.

L'ensemble des réseaux métalliques 102i peut être vu comme un réseau métallique plan avec une période de répétition P constante de motifs métalliques dont l'écart Wi entre les motifs adjacents est susceptible de varier d'un filtre de couleur à l'autre.

Le filtre 100 selon l'invention correspond donc à un filtre de transmission de type Fabry-Pérot de l'état de l'art modifié en ce qu'un réseau métallique discontinu avec une période de répétition de motifs strictement inférieure à la longueur d'onde de transmission remplace l'un des réflecteurs continus du filtre. L'autre réflecteur reste un film métallique mince continu comme dans un filtre à cavité de Fabry-Pérot connu.

Avantageusement, la période de réseau est la même pour tous les filtres spectraux de couleur Fi contrairement à l'état de la technique où la période de réseau est différente pour les différents filtres de couleur.

La longueur d'onde de transmission dans la structure de chaque filtre Fi peut être obtenue en optimisant l'épaisseur Ti de la cavité diélectrique 103i selon les méthodes mentionnées plus haut et dans une moindre mesure l'écart Wi entre chaque motif d'un réseau métallique 102i. La bande passante de transmission correspondant à une longueur d'onde donnée peut être contrôlée en ajustant l'écart Wi entre chaque motif d'un réseau métallique 102i et l'épaisseur EG du réseau métallique 102i.

L'épaisseur EG des réseaux métalliques 102i est préférentiellement supérieure à l'épaisseur EC des couches réfléchissantes métalliques continues 104i.

L'épaisseur EG des réseaux métalliques 102i est préférentiellement supérieure à la profondeur de pénétration du métal, c'est-à-dire l'épaisseur du métal (minimale) à laquelle l'onde électromagnétique peut se transmettre avec une perte d'énergie minimale (le métal est plus ou moins transparent), pour que le réseau métallique agisse en tant que réflecteur. L'épaisseur EG doit donc être supérieure à cette valeur (généralement la profondeur de pénétration des métaux est d'environ 5 à 10 nm)

Comme nous allons le voir dans ce qui suit, le filtre 100 selon l'invention permet d'obtenir des filtres résonnants à plusieurs longueurs d'onde avec une transmission maximale satisfaisante pour chaque longueur d'onde et une bande passante suffisamment étroite et sensiblement constante pour toutes les longueurs d'onde.

Le filtre 100 selon l'invention comporte également optionnellement une surcouche diélectrique 105 déposée au-dessus des couches métalliques continues 104i.

Le filtre 100 selon l'invention peut également comporter une pluralité de transducteurs (au moins deux) photoélectriques non représentés (ici 4 transducteurs photoélectriques serait nécessaire) en regard de chaque filtre de couleur Fi. Les transducteurs peuvent être sous le substrat 101, formés à l'intérieur de ce dernier ou au-dessus de ce dernier. Les transducteurs photoélectriques peuvent fonctionner soit en tant que collecteur de lumière issue des filtres soit en tant qu'émetteur de lumière vers les filtres. S'il s'agit de collecteurs, les transducteurs peuvent être par exemple des photodiodes de type CMOS. S'il s'agit d'émetteurs, les transducteurs peuvent être par exemple des diodes LED, des diodes de type QLED ou des diodes LASER, les émetteurs présentant dans ce cas un spectre d'émission plus large que celui des cavités de Fabry-Pérot correspondantes.

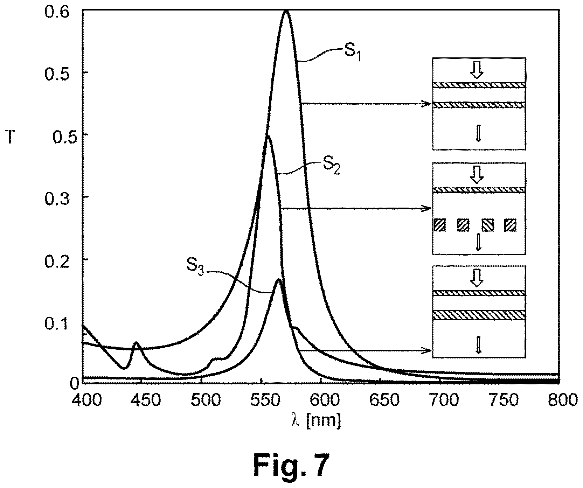

Afin d'illustrer les performances du filtre selon l'invention, la figure 7 montre une comparaison des spectres de transmission pour trois structures de filtre de couleur différentes :

- Spectre S1 avec un filtre de couleur ayant des couches métalliques minces continues d'un filtre de Fabry-Pérot selon l'état de l'art,

- Spectre S2 avec un filtre de couleur ayant une couche continue et un réseau métallique tels qu'utilisés dans la présente invention,

- Spectre S3 avec un filtre ayant une couche métallique épaisse et une couche métallique plus fine telles que présentées en figure 2.

La comparaison est faite pour une épaisseur de cavité diélectrique constante de 140 nm et les structures de filtre suivante :

- (a) Pour le spectre S1: Filtre de Fabry-Pérot avec de fines couches métalliques de 30 nm d'épaisseur,

- (b) Pour les spectre S2: Structure de filtre de couleur selon l'invention où la couche métallique inférieure est un réseau métallique. La période de réseau utilisée pour cette illustration est de 290 nm et l'écart entre les motifs métalliques est de 150 nm. L'épaisseur du réseau métallique est de 60 nm,

- (c) Pour les spectre S3: Filtre de Fabry-Pérot avec une épaisseur de couche métallique supérieure continue de 30 nm et une épaisseur de couche métallique inférieure continue de 60 nm.

Dans la simulation présentée, l'angle d'incidence est un angle normal tandis qu'une polarisation magnétique transversale est utilisée.

L'argent Ag est ici utilisé comme métal pour les couches réfléchissantes et la cavité, le substrat et le matériau de recouvrement sont réalisés en SiO2 avec un indice de réfraction constant de 1,46 à des fins d'illustration. Le choix des matériaux et des dimensions ne se limite évidemment pas à celui présenté ici.

Comme on peut le voir sur la figure 7, l'utilisation d'une épaisseur plus importante de couche continue métallique (spectre S3) permet de rendre plus étroite la bande passante de transmission par rapport à celle du spectre S1 d'un filtre Fabry-Pérot standard: toutefois, l'augmentation de l'épaisseur entraîne une diminution de la transmission maximale. L'utilisation d'une structure de réseau métallique épaisse conforme à l'invention permet d'augmenter le coefficient de transmission tout en ayant une bande passante étroite (- 25 nm).

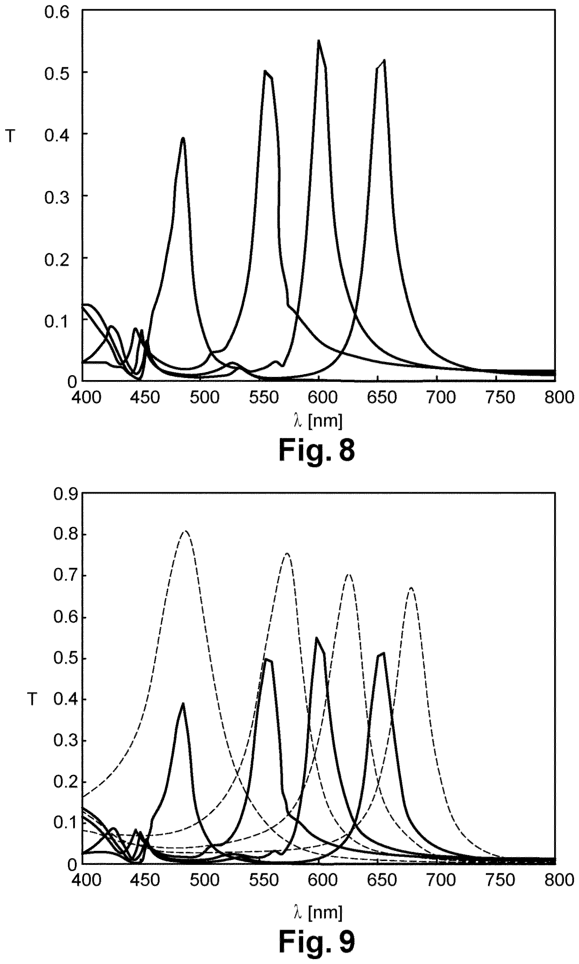

La figure 8 montre la réponse spectrale d'un filtre multispectral tel que celui de la figure 6 avec les dimensions suivantes pour chaque filtre de couleur Fi :

|  | F1 | F2 | F3 | F4 |
|---|---|---|---|---|
| P (nm) | 290 | 290 | 290 | 290 |
| Ti (nm) | 110 | 140 | 160 | 180 |
| Wi (nm) | 50 | 150 | 120 | 90 |
| λ (nm) | 485 | 555 | 600 | 655 |
| LMH (nm) | ~25 | ~25 | ~25 | ~25 |

L'épaisseur de la couche réfléchissantes continue est égale à 30 nm pour chacun des filtres de couleur et l'épaisseur des motifs du réseau métallique pour chaque filtre de couleur est de 60 nm.

On constate sur la figure 8 et le tableau ci-dessus qu'il est possible grâce au filtre selon l'invention d'obtenir une bande passante quasi-constante et étroite (la largeur à mi-hauteur LMH est environ égale à 25 nm quelle que soit la couleur) pour toutes les longueurs d'onde correspondant chacune à une couleur donnée tout en gardant une période P de répétition des motifs des réseaux métalliques identique et en ajustant uniquement la valeur de l'écart Wi entre les motifs pour chaque longueur d'onde (la valeur de la longueur d'onde étant quant à elle essentiellement fixée par l'épaisseur Ti des motifs diélectriques de la cavité de Fabry-Pérot).

La figure 9 montre la réponse spectrale de la figure 8 à laquelle on superpose (en pointillés) la réponse spectrale d'un filtre multispectral selon l'état de l'art à cavités de Fabry-Pérot avec des couches réfléchissantes continues d'une épaisseur de 30nm.

Le tableau ci-dessous donne les largeurs à mi-hauteur pour chacun des filtres de couleur respectivement du filtre selon l'invention et du filtre selon l'état de l'art.

|  | F1 | F2 | F3 | F4 |
|---|---|---|---|---|
| λ (nm) | 485 | 555 | 600 | 655 |
| LMH (nm) filtre selon l'invention | ~25 | ~25 | ~25 | ~25 |
| LMH (nm) filtre selon l'état de l'art | ~60 | ~40 | ~35 | ~30 |

On constate donc qu'en dépit d'une transmission maximale plus élevée, le filtre selon l'état de l'art ne permet pas d'obtenir une bande passante sensiblement identique pour chaque filtre de couleur

En outre, du point de vue du procédé de fabrication, il est clair que le filtre selon l'invention offre davantage de paramètres à faire varier pour régler à la fois la longueur d'onde, la transmission maximale et la bande passante tandis que la filtre de l'état de l'art impose de fixer précisément la longueur d'onde en fonction de l'épaisseur du motif diélectrique sans qu'il soit possible de corriger ou compenser certaines limitations liées à la fabrication. A l'inverse, avec le filtre selon l'invention, le fait de pouvoir faire varier l'écart Wi permet d'influer sur la transmission et sur la bande passante. De même, le fait d'ajuster la période permet d'influer sur la transmission et sur la bande passante. Bien entendu, il est également possible de jouer sur l'épaisseur des motifs du réseau métallique et/ou sur l'épaisseur de la couche métallique afin d'obtenir les propriétés du filtre recherchées.

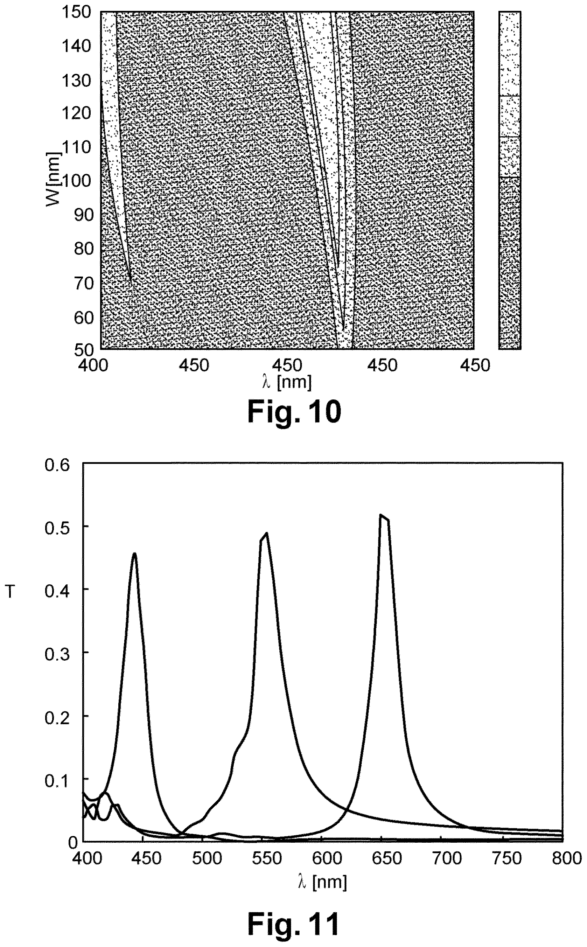

La figure 10 montre une cartographie de transmission en fonction de l'écart W entre les motifs d'un réseau métallique d'un filtre de couleur d'un filtre multispectral selon l'invention, pour une période de réseau de 290 nm et une épaisseur de cavité diélectrique de 180 nm. On peut voir qu'un réglage fin de la longueur d'onde peut également être obtenu en choisissant de manière appropriée l'écart W.

La sélection de la période P de répétition des motifs du réseau métallique peut être arbitraire à condition que cette période soit de dimension inférieure à la longueur d'onde (en d'autres termes, la période P doit être strictement inférieure à la plus petite longueur d'onde à filtrer). L'écart Wi entre les motifs peut être optimisé séparément une fois que l'épaisseur Ti de la cavité est déterminée. La figure 11 montre un autre exemple de réponse spectrale d'un filtre multispectral selon l'invention avec une période P de 260 nm et des épaisseurs de cavité Ti prédéterminées pour filtrer 3 canaux de couleur (ici spécifiquement bleu, vert et rouge). L'écart Wi entre les motifs de chaque réseau métallique correspondant à une couleur a été optimisé séparément pour obtenir une transmission la plus élevée possible tout en ayant une bande passante étroite (toujours de l'ordre de 25 nm) pour chacune des longueurs d'onde.

Les dimensions du filtre multispectral selon l'invention simulé en figure 11 sont données dans le tableau ci-dessous pour chaque filtre de couleur Fi :

|  | F1 | F2 | F3 |
|---|---|---|---|
| P (nm) | 260 | 260 | 260 |
| Ti (nm) | 90 | 140 | 180 |
| Wi (nm) | 70 | 130 | 70 |
| λ (nm) | 450 | 555 | 650 |
| LMH (nm) | ~25 | ~25 | ~25 |

On notera au passage que les écarts W1 et W3 sont identiques pour des longueurs d'onde différentes des filtres de couleur respectifs F1 et F2.

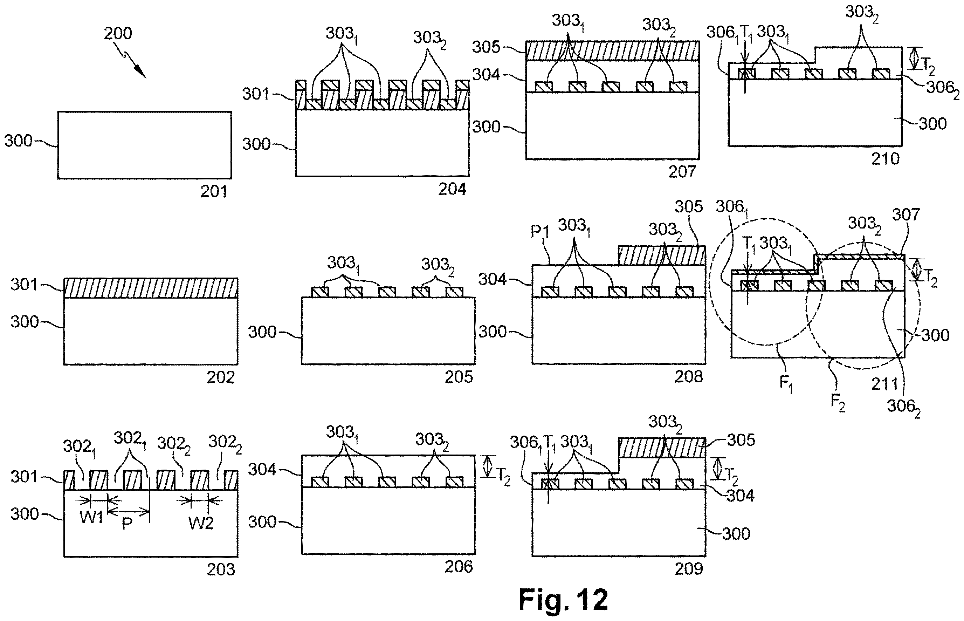

La figure 12 montre les différentes étapes d'un procédé 200 de fabrication d'un filtre multispectral selon l'invention.

La première étape 201 du procédé 200 consiste à partir d'un substrat 300 qui peut par exemple être un substrat en Si, un substrat Silicium sur Isolant SOI (pour « Silicon On Insulator » selon la terminologie anglaise) ou un substrat en verre ou en saphir.

L'étape 201 est suivie d'une étape 202 consistant à déposer sur le substrat 300, une couche de résine 301.

Le procédé 200 comporte ensuite une étape 203 de structuration de la couche de résine 301 visant à créer des espaces 302i par lithographie en retirant de la matière dans la couche de résine 301 : les espaces 302i sont destinés à recevoir les motifs métalliques du réseau métallique de chaque filtre de couleur. Selon l'invention, il convient d'avoir au moins deux séries d'espaces correspondant à au moins deux filtres de couleur. Ici, par souci d'illustration uniquement, deux séries d'espaces 3021 et 3022 sont représentés, correspondant chacun à un filtre de couleur. Cette étape permet ainsi de fixer non seulement la période P de répétition dans chaque réseau métallique (correspondant à la largeur du motif de résine de chaque série auquel on ajoute la largeur d'un espace de la série) mais aussi l'écart Wi (correspondant à la largeur d'un motif) entre chaque motif d'un réseau métallique.

Le procédé 200 comporte ensuite une étape 204 de dépôt de métal à la fois dans les espace 302i mais aussi au-dessus des zones de résine de la couche 301 restantes. Ce dépôt permet de former les motifs métalliques 303i dans les espaces 302i pour chacun des réseaux métalliques correspondant à un filtre de couleur. Le métal peut être déposé de façon conforme par dépôt chimique par phase vapeur CVD (Chemical Vapor Déposition en anglais) ou dépôt physique par phase vapeur PVD

(Physical Vapor Déposition). L'épaisseur de métal déposé est par exemple de l'ordre de 60 nm.

L'étape de dépôt de métal est suivie d'une étape 205 de retrait du métal restant sur la résine et de la résine restante afin de conserver uniquement les motifs métalliques 303i.

Le procédé 200 selon l'invention comporte alors une étape 206 de dépôt d'une couche de matériau diélectrique 304 destiné à former les motifs diélectriques de chacun des filtres de couleur du filtre selon l'invention. Cette couche 304 est éventuellement planarisée par une étape de gravure de type etch-back éventuellement et/ou une étape de polissage mécano-chimique CMP (Chemical Mechanical Polishing selon la terminologie anglaise). Le matériau de la couche 304 est préférentiellement mais non limitativement un matériau transparent dans le domaine du visible tel qu'un matériau organique du type polymère ou inorganique (oxyde, nitrure de silicium, alumine, ...). Le dépôt est par exemple un dépôt réalisé par une technique de dépôt physique par phase vapeur PVD (Physical Vapor Déposition) ou de dépôt chimique par phase vapeur CVD (Chemical Vapor Déposition en anglais) ou de dépôt chimique par phase vapeur à basse pression LPCVD (Low Pressure Chemical Vapor Déposition en anglais) ou de dépôt chimique par phase vapeur assisté par plasma PECVD (Plasma Enhanced Chemical Vapor Déposition en anglais). Il convient de noter que l'invention ne se limite pas au domaine du visible et que d'autres matériaux transparents à d'autres longueurs d'onde, dans l'infrarouge par exemple (par exemple en utilisant du silicium), peuvent être utilisés. On notera que le matériau diélectrique vient combler les espaces entre les motifs métalliques 303i. L'épaisseur de la couche diélectrique 304 (le cas échéant après planarisation) est choisie pour correspondre à la hauteur de la cavité diélectrique la plus épaisse (ici désigné par l'épaisseur T2) pour l'ensemble des filtres de couleur.

L'étape 206 est suivie d'une étape 207 de dépôt d'une seconde couche de résine 305 sur la couche 304 diélectrique.

Selon l'étape 208, on structure, par exemple par lithographie, la couche 305 de résine de façon à laisser apparente la zone P de la couche diélectrique 304 correspondant au motif diélectrique du premier filtre de couleur à former.

L'étape 208 est suivie d'une étape 209 durant laquelle on grave la couche diélectrique dans la zone P sur une épaisseur T1 donnée de façon à obtenir l'épaisseur du motif diélectrique 3061 de cavité de Fabry-Pérot recherchée. Cette gravure peut être une gravure sèche ou humide.

Les étapes 207 à 209 peuvent être répétées dans l'hypothèse où plus deux filtres de couleurs doivent être obtenus.

L'étape 210 consiste ensuite à retirer la résine restante 305 de façon à libérer en surface le motif diélectrique 3062 de cavité Fabry-Pérot d'épaisseur T2.

L'étape 211 consiste alors à déposer une couche métallique réfléchissante 307, par exemple d'une épaisseur comprise entre 20 et 50 nm, recouvrant les motifs diélectriques 3061 et 3062 de façon à former la couche réfléchissante continue des filtres de couleurs F1 et F2 du filtre selon l'invention. Les deux filtres de couleurs F1 et F2 sont ainsi formés respectivement par :

- Les réseaux de motifs métalliques 3031 et 3032 de période P et d'écart respectif W1 et W2 ;

- Les motifs diélectriques de cavité 3061 et 3062 ;

- La couche réfléchissante métallique continue 307.

Cette couche réfléchissante continue 307 plane est déposée de façon conforme par dépôt chimique par phase vapeur CVD (Chemical Vapor Déposition en anglais) ou dépôt physique par phase vapeur PVD (Physical Vapor Déposition).

A l'issue du procédé de fabrication selon ce premier mode de réalisation de l'invention, on obtient un filtre multispectral conforme à celui de la figure 6 dans lequel les réseaux métalliques sont localisés sur la partie inférieure du filtre tandis que les couches réfléchissantes continues sont localisées sur la partie supérieure du filtre.

Nous allons voir dans ce qui suit qu'il est également possible d'avoir un filtre multispectral selon un second mode de réalisation de l'invention.

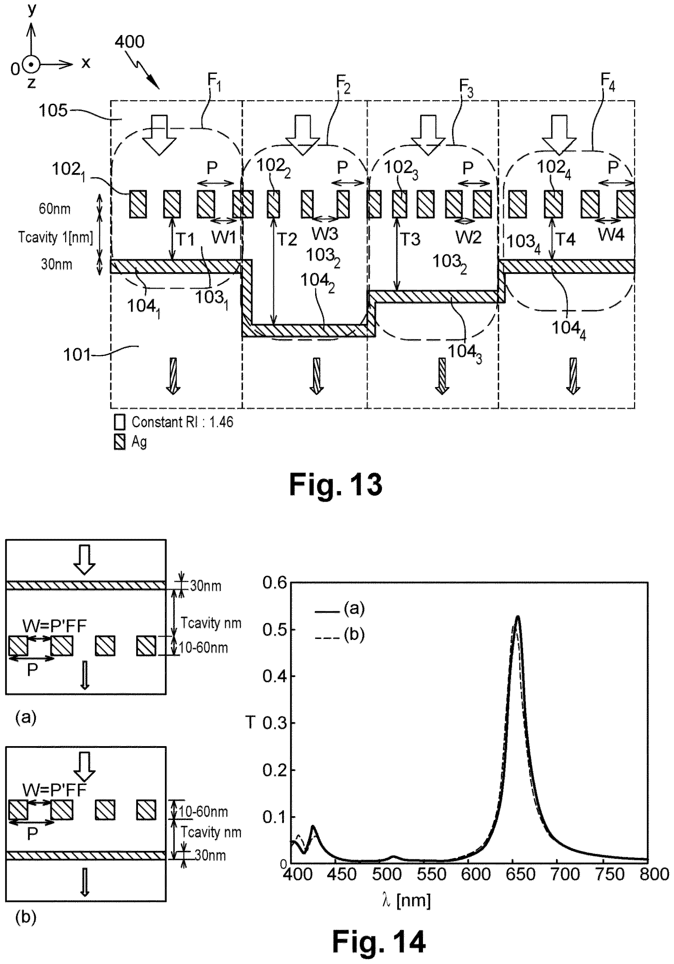

Ce filtre 400 selon un second mode de réalisation de l'invention est représenté schématiquement en figure 13. Sa structure est identique à celle du filtre selon le premier mode de réalisation de l'invention représenté en figure 6. La seule différence entre le filtre 400 et le filtre 100 consiste à inverser la position des couches réfléchissantes métallique continues 104i et des réseaux métalliques 102i ; ainsi, en figure 13, les réseaux métalliques 102i sont localisés sur la partie supérieure des cavités de Fabry-Pérot alors qu'ils étaient en partie inférieure dans le filtre de la figure 6. Par souci de clarté, les numéros de référence des éléments structurels et des dimensions sont communs aux deux filtres 100 et 400.

La figure 14 montre la superposition de la réponse spectrale de deux filtres de couleur, l'un utilisé dans le filtre 100 de la figure 6 (trait plein) et l'autre utilisé dans le filtre 400 de la figure 13 (pointillé). Les dimensions choisies sont les mêmes pour les deux filtres de couleur avec une épaisseur de motif diélectrique T de 180 nm, une période P de répétition des motifs métalliques du réseau de 260 nm et un écart W entre les motifs métallique du réseau de 70 nm. On constate que les deux réponses spectrales se superposent : il est donc possible d'utiliser indifféremment la structure du filtre 100 et du filtre 400 sans modification de la réponse spectrale.

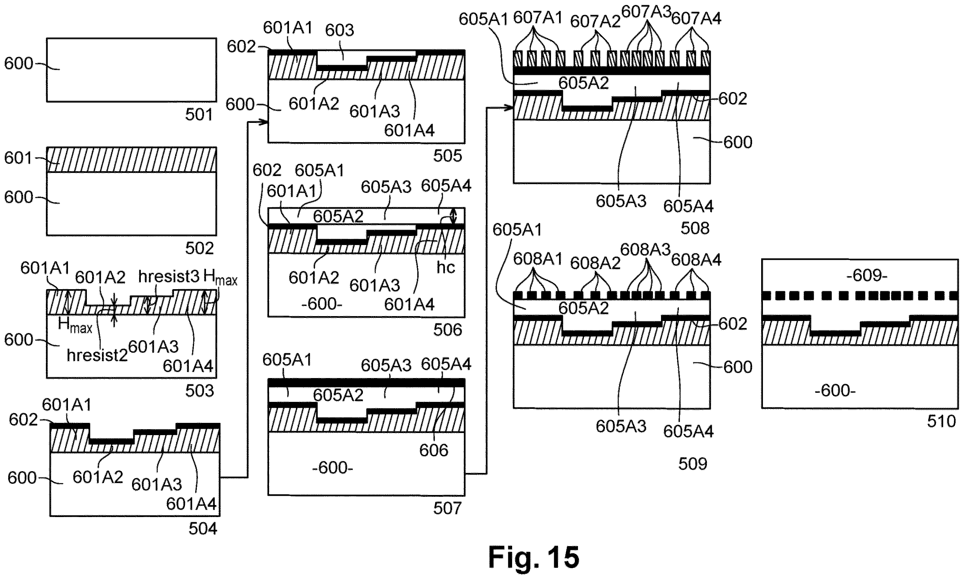

La figure 15 montre les différentes étapes d'un procédé 500 de fabrication d'un filtre multispectral selon le second mode de réalisation de l'invention.

La première étape 501 du procédé 500 consiste à partir d'un substrat 600 qui peut par exemple être un substrat en Si, un substrat Silicium sur Isolant SOI (pour « Silicon On Insulator » selon la terminologie anglaise) ou un substrat en verre ou en saphir.

L'étape 501 est suivie d'une étape 502 consistant à déposer sur le substrat 300, une couche de résine 301.

Selon l'étape 503, la couche de résine 601 est alors structurée. La structuration de la couche de résine 601 est réalisée par une étape de lithographie. Cette lithographie peut être préférentiellement une lithographie en niveaux de gris ou Grayscale selon la terminologie anglaise électronique ou optique. D'autres techniques de lithographie telles que la lithographie à deux photons ou par nano-impression peuvent également être utilisées pour la réalisation de la structure en résine 601.

La couche de résine structurée 601 comporte une pluralité de motifs 601Ai (ici 4 motifs 601A1, 601A2, 601A3 et 601A4).

Selon l'invention, il convient d'avoir au moins deux motifs 601Ai de résine de hauteurs différentes. Parmi l'ensemble de ces motifs 601Ai, l'un d'eux ou plusieurs, ici les motif 601A1 et 601A4, présente une hauteur maximale Hmax, dite de référence, la hauteur étant mesurée perpendiculairement au plan du substrat 600. De façon plus générale, la hauteur du motif 601Ai sera noté $h_{resist-i}$. Ainsi, sur la figure 15, Hmax est égal à hresist-1 et hresist-4.

L'étape 503 est suivie d'une étape 504 de dépôt d'une couche métallique réfléchissante 602, par exemple d'une épaisseur comprise entre 20 et 50 nm, recouvrant les motifs 601Ai de la sous-couche structurée 401. Cette couche réfléchissante 602 forme la première couche réfléchissante des filtres de couleurs de type cavité de Fabry-Pérot à venir. La couche réfléchissante 602 doit a minima recouvrir de façon continue chaque surface supérieure des motifs 601Ai étant entendu qu'elle pourrait également être déposée sur les flancs des motifs 601Ai. Cette couche réfléchissante 602 est par exemple déposée de façon conforme par dépôt chimique par phase vapeur CVD (Chemical Vapor Déposition en anglais) ou dépôt physique par phase vapeur PVD (Physical Vapor Déposition). Le dépôt conforme permet d'avoir une épaisseur de la couche réfléchissante 602 constante, a minima sur le dessus des motifs.

L'étape suivante non représentée consiste à déposer une couche réalisée dans le matériau diélectrique destiné à former les motifs diélectriques des cavités de Fabry-Pérot. La couche de matériau diélectrique recouvre la totalité des motifs 601Ai recouvertes de la couche réfléchissante 602. La couche présente une surface supérieure (non nécessairement plane) dont chaque point est situé à une hauteur, relativement au substrat 600, supérieure à la hauteur maximale de référence Hmax. Le matériau de la couche est préférentiellement mais non limitativement un matériau transparent dans le domaine du visible tel qu'un matériau organique du type polymère ou inorganique (oxyde, nitrure de silicium, alumine, ...). Le dépôt est préférentiellement un dépôt conforme par exemple réalisé par une technique de dépôt physique par phase vapeur PVD (Physical Vapor Déposition) ou de dépôt chimique par phase vapeur CVD (Chemical Vapor Déposition en anglais) ou de dépôt chimique par phase vapeur à basse pression LPCVD (Low Pressure Chemical Vapor Déposition en anglais) ou de dépôt chimique par phase vapeur assisté par plasma PECVD (Plasma Enhanced Chemical Vapor Déposition en anglais).

Le procédé 500 comporte alors une étape 505 de planarisation de la couche réalisée dans le matériau diélectrique destiné à former les motifs diélectriques des cavités de Fabry-Pérot de façon à former une couche 603 planarisée en surface par retrait du matériau diélectrique de la couche diélectrique préalablement déposée. La planarisation s'effectue avec arrêt sur la couche réfléchissante 602 située à son niveau le plus haut (i.e. au niveau de la hauteur de référence des motifs 601A1 et 601A4).

Le procédé 500 selon l'invention comporte ensuite une étape 506 de dépôt conforme d'une couche 604 du même matériau diélectrique destiné à former les motifs diélectriques des cavités de Fabry-Pérot. Cette étape est par exemple réalisée par une technique de dépôt PVD, CVD, LPCVD ou PECVD. La hauteur de la couche 604 est notée hc, la hauteur étant mesurée perpendiculairement au plan du substrat 600. Après cette étape, on obtient une pluralité de motifs diélectriques de cavité de Fabry-Pérot 605Ai (ici quatre motifs 605A1, 605A2, 605A3 et 605A4).

La hauteur hdiel_i du motif 605Ai peut être déterminée selon les méthodes mentionnées plus haut. Selon le procédé selon l'invention, on fixe la hauteur hdiel_i par la formule suivante : hdiel_i = Hmax - $h_{resist-i}$ + hc.

Ainsi, pour les motifs 605A1 et 605A4, hdiel_1 et hdiel_4 sont ici directement égale à la hauteur hc de la couche 604.

De façon plus générale, pour chaque motif 605Ai, la hauteur est déterminée technologiquement par la différence de hauteur entre celle du motif de résine 601A1 le plus haut Hmax et la hauteur du motif de résine 601Ai à laquelle on ajoute la hauteur de la seconde couche 604 de diélectrique.

L'étape 507 du procédé 500 consiste alors à déposer une seconde couche métallique 606, d'une épaisseur préférentiellement supérieure à celle de la première couche métallique 602, par exemple de l'ordre de 60 nm, recouvrant les motifs de cavités de Fabry-Pérot 605Ai. Cette couche métallique 602 plane et continue est destinée à former le réseau supérieur de motifs métalliques des filtres de couleurs de type cavité de Fabry-Pérot. La couche métallique 606 est déposée de façon conforme par dépôt CVD ou PVD.

Le procédé 500 comporte ensuite une étape 508 de structuration d'une couche de résine visant à créer des espaces 607Ai par lithographie par retrait de matière dans la couche de résine.

Les espaces 607Ai sont destinés à recevoir les motifs métalliques du réseau métallique de chaque filtre de couleur. Selon l'invention, il convient d'avoir au moins deux séries d'espaces correspondant à au moins deux filtres de couleur. Ici, par souci d'illustration uniquement, quatre séries d'espaces 607A1 à 607A4 sont représentés, correspondant chacun à un filtre de couleur. Cette étape permet ainsi de fixer non seulement la période P de répétition dans chaque réseau métallique (correspondant à la largeur du motif de résine de chaque série auquel on ajoute la largeur d'un espace de la série) mais aussi l'écart Wi (correspondant à la largeur d'un espace de la série) entre chaque motif d'un réseau métallique.

L'étape 509 consiste alors à réaliser une gravure du métal de la couche métallique 606 non protégé par la résine pour créer les motifs métalliques 308i dans pour chacun des réseaux métalliques correspondant à un filtre de couleur.

L'étape 510 consiste à déposer optionnellement une surcouche diélectrique 609 planarisée au-dessus des réseau de motifs métalliques continues et entre ces derniers.

## Revendications

1. Filtre multispectral (100, 400) pour une radiation électromagnétique, ledit filtre comportant au moins deux filtres de couleur (Fi), chaque filtre de couleur comportant :

   - un réseau métallique comportant des motifs métalliques (102i) répétés selon une période donnée (P), chaque motif métallique étant espacé d'un motif métallique adjacent d'un écart (Wi) donné non nul ;
- une couche réfléchissante continue (104i) ;
- un motif (103i) de matériau diélectrique de cavité de Fabry-Pérot entre le réseau métallique et la couche réfléchissante continue ;

l'épaisseur (Ti) des motifs de matériau diélectrique des deux filtres de couleur étant différente.

2. Filtre multispectral selon la revendication 1 **caractérisé en ce que** la période de répétition des motifs métalliques est identique pour les deux filtres de couleur.

3. Filtre multispectral selon l'une des revendications précédentes **caractérisé en ce que** l'épaisseur du réseau métallique des deux filtres de couleur est identique.

4. Filtre multispectral selon l'une des revendications précédentes **caractérisé en ce que** l'épaisseur de la couche réfléchissante des deux filtres de couleur est identique.

5. Filtre multispectral selon l'une des revendications précédentes **caractérisé en ce que** chacun des deux filtres est en regard d'un transducteur photoélectrique.

6. Filtre multispectral selon l'une des revendications précédentes **caractérisé en ce que** l'espace entre chaque motif métallique est rempli du matériau diélectrique formant les motifs de matériau diélectrique de cavité de Fabry-Pérot des filtres de couleur.

7. Filtre multispectral selon l'une des revendications précédentes **caractérisé en ce que** la période de répétition des motifs métalliques de chaque réseau métallique est choisie pour être strictement inférieure à la longueur d'onde du filtre de couleur correspondant.

8. Procédé (200) de fabrication d'un filtre multispectral pour une radiation électromagnétique selon l'une des revendications précédentes **caractérisé en ce qu'**il comporte les étapes suivantes :

   - Dépôt (202) d'une première couche de résine sur un substrat ;
   - Structuration (203) de la première couche de résine de façon à obtenir au moins deux séries de tranchées dans la première couche de résine, chaque tranchée d'une série étant espacée d'une tranchée adjacente de la série d'un écart donné non nul, les tranchées étant répétées selon une période donnée ;
   - Dépôt (204) d'une couche de métal dans les tranchées et sur la résine restante ;
   - Retrait (205) de la résine restante et du métal se trouvant sur la résine restante de façon à conserver deux réseaux métalliques comportant chacun des motifs métalliques répétés selon la période donnée d'une des séries de tranchées, chaque motif métallique étant espacé d'un motif métallique adjacent de l'écart donné non nul d'une des séries de tranchées ;
   - Dépôt (206) d'une couche de matériau diélectrique plane destinée à former au moins deux motifs de matériau diélectrique de cavité de Fabry-Pérot, ladite couche présentant l'épaisseur du motif diélectrique de cavité de Fabry-Pérot maximale ;
   - Dépôt (207, 208) d'une couche de résine sur la couche de matériau diélectrique et retrait de ladite couche de résine avec arrêt sur la couche diélectrique au niveau la zone au-dessus d'un des deux réseaux métalliques ;
   - Gravure (209) de la couche diélectrique au niveau de la zone de retrait de résine de façon à obtenir un premier motif diélectrique de cavité Fabry-Pérot ;
   - Retrait (210) de la résine restante de façon à laisser apparent un second motif diélectrique de cavité Fabry-Pérot présentant l'épaisseur de motif diélectrique maximale, l'épaisseur du premier motif diélectrique étant inférieure à l'épaisseur du premier motif diélectrique ;
   - Dépôt (211) d'une couche métallique continue sur les premier et deuxième motifs diélectrique.

9. Procédé (500) de fabrication d'un filtre multispectral pour une radiation électromagnétique selon l'une des revendications 1 à 7 **caractérisé en ce qu'**il comporte les étapes suivantes :

   - Dépôt (502) sur un substrat d'une couche de matériau de structuration;
   - Structuration (503) de la couche de matériau de structuration de sorte à obtenir au moins deux motifs de matériau de structuration de hauteurs différentes, au moins un des motifs présentant une hauteur maximale de référence relativement au substrat, la hauteur étant mesurée perpendiculairement au plan du substrat ;

- Dépôt (504) d'une couche métallique continue sur les au moins deux motifs de matériau de structuration ;
- Dépôt d'une couche réalisée dans le matériau diélectrique destiné à former au moins deux motifs diélectriques de cavités de Fabry-Pérot, ladite couche de matériau diélectrique recouvrant la totalité des motifs de matériau de structuration en présentant une surface supérieure dont chaque point est situé à une hauteur supérieure à la hauteur maximale de référence ;
- Planarisation (505) par retrait du matériau diélectrique avec arrêt sélectif au sommet du motif de matériau de structuration le plus haut recouvert de la couche métallique continue ;
- Dépôt (506) d'une couche réalisée dans le même matériau diélectrique de façon à finaliser la formation des au moins deux motifs diélectriques de cavité Fabry-Pérot ;
- Dépôt (507) d'une seconde couche métallique sur les au moins deux motifs de cavités diélectriques de cavité Fabry-Pérot ;
- Structuration (508, 509) de la seconde couche métallique de façon à former au moins deux réseaux métalliques comportant chacun des motifs métalliques répétés selon une période donnée, chaque motif métallique étant espacé d'un motif métallique adjacent d'un écart donné non nul.

10. Procédé (500) de fabrication selon la revendication précédente **caractérisé en ce que** le matériau de structuration est une résine, ladite étape de structuration étant réalisée par une étape de lithographie en niveau de gris dite Grayscale sur la couche de matériau de structuration.

**Fig. 1**

**Fig. 2**

**Fig. 3**

**Fig. 4**

Pixel 1      Pixel 2      Pixel 3

30

33P2

33P1

32P1   W1

31P1

W2

32P2

W3

32P3

33P3

31P3

P1      P2      P3

31P2

☐ Diélectric
▨ Métal

## Fig. 5

100

$104_1$   $F_1$   $104_2$   $F_2$   $104_3$   $F_3$   $104_4$   $F_4$

$103_3$

$103_1$

$103_2$

T2

T3

EC=30nm

$102_2$

$102_1$

W1   T1   W2   W3   $102_3$   W4   T4   $103_4$

$102_4$

EG=60nm

P    P    P    P

101

y
0 ⊙ → x
z

☐ Constant RI : 1.46
▨ Ag

## Fig. 6

Fig. 7

Fig. 8

Fig. 9

Fig. 10

Fig. 11

Fig. 12

EP 4 528 337 A2

**Fig. 13**

**Fig. 14**

Fig. 15

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **I. L. GOMES DE SOUZA** ; **V. F. RODRIGUEZ-ESQUERRE** ; **D. F. RÊGO**. Filtres grand angle à base de nanorésonateurs pour le spectre visible. *Appl. Opter.*, 2018, vol. 57, 6755-6759

- **SAKAT**. Structures métal-diélectriques à résonance de mode guidé et applications au filtrage et à l'imagerie infrarouge. *Optics / Photonic. Ecole Polytechnique X*, 2013